Europäisches Patentamt

European Patent Office

Office européen des brevets

(19)

(11) Veröffentlichungsnummer: **0 071 243**

**A2**

(12) **EUROPÄISCHE PATENTANMELDUNG**

(21) Anmeldenummer: 82106778.2

(22) Anmeldetag: 27.07.82

(51) Int. Cl.³: **H 01 J 37/304**

(30) Priorität: 30.07.81 US 288636

(43) Veröffentlichungstag der Anmeldung:
09.02.83 Patentblatt 83/6

(84) Benannte Vertragsstaaten:
DE FR GB IT

(71) Anmelder: International Business Machines
Corporation

Armonk, N.Y. 10504(US)

(72) Erfinder: Pfeiffer, Hans Christian
25 Ketcham Road
Ridgefield Connecticut 06877(US)

(74) Vertreter: Neuland, Johannes, Dipl.-Ing.
Schönaicher Strasse 220
D-7030 Böblingen(DE)

(54) Verfahren und Vorrichtung zum Korrigieren der Ausrichtung eines Elektronenstrahles.

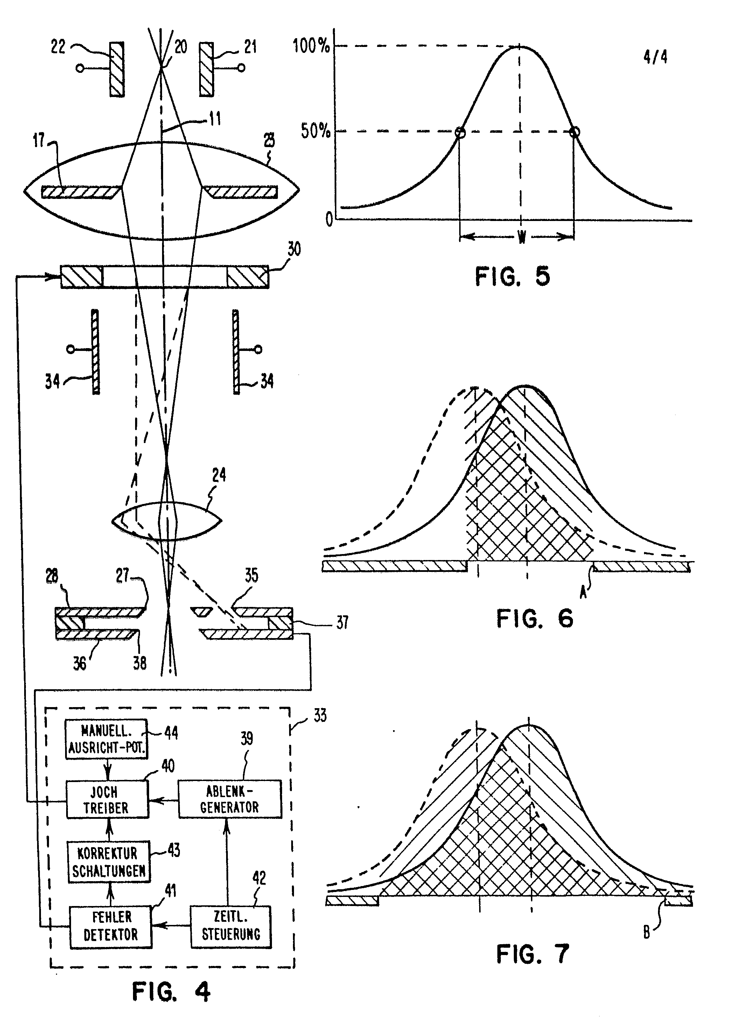

(57) Zum Korrigieren der Ausrichtung eines Elektronenstrahles, mit dem eine Auftreffplatte (12) beaufschlagt wird, wird die Strahlquelle (10) elektronenoptisch auf eine zentrale, kreisförmige Öffnung (27; Fig. 4) einer Ausblendplatte (28) abgebildet. Zu ausgewählten Zeiten wird das Bild der Strahlquelle auf eine zweite kreisförmige Öffnung (35) in der Ausblendplatte abgelenkt. Mittels eines Ablenk-Joches (30) erfolgt ein genaues Ausrichten des Bildes der Strahlquelle auf diese zweite Öffnung. Deren Durchmesser entspricht etwa der Halbwertsbreite W der Stromdichteverteilung des Bildes der Strahlquelle in dieser Öffnung. Das genaue Ausrichten des Bildes der Strahlquelle auf die zweite Öffnung erfolgt durch kleine Verschiebungen des Bildes. Diese werden beendet, wenn der die zweite Öffnung durchfließende Elektronenstrom einen Maximalwert annimmt. Dann wird der Elektronenstrahl wieder zu der zentralen kreisförmigen Öffnung der Ablenkplatte gelenkt. Deren Durchmesser beträgt mindestens etwa das doppelte der Halbwertsbreite W der Stromdichteverteilung des Bildes der Strahlquelle in dieser Öffnung. Dadurch bleiben die zur Ausrichtung des Elektronenstrahles vorgenommenen Verschiebungen des Bildes der Strahlquelle ohne merklichen Einfluß auf den die zentrale Öffnung durchfließenden Elektronenstrom, der zur Auftreffplatte gelangt.

./...

EP 0 071 243 A2

Croydon Printing Company Ltd.

FIG. 4

VERFAHREN UND VORRICHTUNG ZUM KORRIGIEREN DER
AUSRICHTUNG EINES ELEKTRONENSTRAHLES

Die Erfindung bezieht sich auf ein Verfahren und eine Vorrichtung zum Korrigieren der Ausrichtung eines Elektronenstrahles.

In dem US Patent 4 243 866 sind ein Verfahren und eine Vorrichtung zum Erzeugen eines Elektronenstrahles mit veränderbarem Querschnitt beschrieben. Dies ermöglicht es, den Elektronenstrahl auf Bereiche verschiedener Größe der Auftreffplatte zu richten, um eine gewünschte Konfiguration in der Auftreffplatte zu bilden. Beispielsweise kann die Auftreffplatte ein Halbleiterwafer sein, in dem integrierte Halbleiterschaltungen gebildet werden sollen, wobei die mit Mustern bedeckten Bereiche unter Verwendung eines Resistmaterials gebildet werden.

Die Vorrichtung nach dem genannten US Patent benutzt eine kreisförmige Öffnung, um die Verteilung der Stromdichte des Elektronenstrahls zu begrenzen. Daher muß der Durchmesser dieser Öffnung in Übereinstimmung mit der halben Breite der Gauß'schen Stromdichteverteilung des Bildes der Elektronenstrahlquelle bemessen werden, um sicherzustellen, daß die Gauß'sche Verteilung der Stromdichte richtig verringert wird, um die Aberrationen in der Projektionslinse zu begrenzen.

Es ist notwendig, daß das Bild der Quelle im Hinblick auf die aus dem genannten US Patent bekannte kreisförmige Öffnung genau zentriert werden kann und daß es während des Belichtungsprozesses stationär bleibt. Die Vorrichtung

FI 980 066

nach dem genannten US Patent benutzte eine Anordnung, um das Bild der Quelle so anzuordnen, daß es sich relativ zu den Ablenkplatten zum Beeinflussen des Strahlquerschnittes an einer Stelle befand, die durch diese Ablenkung des Elektronenstrahls nicht beeinflußt wird, um an der Auftreffplatte einen Leuchtfleck des Elektronenstrahles mit variablem Querschnitt zu erzeugen.

Obwohl die Einrichtung nach dem genannten US Patent zufriedenstellend arbeitet, wurde gefunden, daß häufige und schwierige Einstellungen z.B. aller der den Querschnitt beeinflussenden Signale für das Ablenken des Strahles mehrmals am Tage notwendig waren, um eine ausreichende Bildqualität aufrechtzuerhalten. Die durch die verschiedenen Komponenten hervorgerufene Drift verursacht eine unerwünschte und bisweilen unannehmbare Verschlechterung des Bildes der Quelle, wenn nicht häufige und schwierige Einstellungen all der Signale zur Querschnittsformung ausgeführt werden. Dies schließt ein, daß das Bild der Quelle sich nicht an der Stelle befindet, an der es von der Ablenkung des Elektronenstrahls unbeeinflußt ist.

Ein anderer Grund für die Verschlechterung des Bildes der Quelle ist auf Änderungen der Lage und der Größe des Heizfadens der Elektronenkanone zurückzuführen. Dieser Heizfaden, der die Form einer Haarnadel hat, ändert seine Konfiguration während eines normalen Brennzyklus so, daß er sowohl seine Lage als auch seine Größe ändert. Daher hat dies auch zusätzlich zu den den Strahlquerschnitt beeinflussenden Signalen eine Wirkung auf die Stelle des Bildes der Quelle.

Während daher die Vorrichtung nach dem genannten US Patent den Durchsatz im Vergleich mit Elektronenstrahlgeräten, in denen keine Leuchtflecke mit veränderbarem Querschnitt verfügbar waren, vergrößert hat, verringert die Notwendigkeit, die den Strahlquerschnitt beeinflussenden Signale mehrmals am Tage neu einzustellen, die Wirksamkeit der Vorrichtung nach dem genannten US Patent.

Wenn die schwierigen Einstellungen der den Strahlquerschnitt beeinflussenden Signale nicht mehrmals am Tage vorgenommen werden, dann tritt eine Variation der Stromdichte des Elektronenstrahls mit veränderbarem Querschnitt an der Auftreffplatte als Folge der Bewegung des Bildes der Quelle an der kreisförmigen Öffnung auf. Dies beeinflußt merklich die Qualität des Strahles mit veränderbarem Querschnitt, so daß das Resistmaterial auf der Halbleiterscheibe, die die Auftreffplatte darstellt, ungleichmäßig entwickelt wird.

Ein Mittel, die Frequenz der Justierungen der den Strahlquerschnitt beeinflussenden Signale zu verringern, besteht darin, die Stromdichte zu vermindern. Jedoch vermindert diese Verringerung der Stromdichte den Durchsatz beträchtlich. Wenn beispielsweise die Auftreffplatte eine Halbleiterscheibe ist, deren Resistmaterial mit dem Elektronenstrahl beaufschlagt wird, verursacht eine Verringerung der Stromdichte von 50% eine Verdoppelung der notwendigen Belichtungszeit für das Resistmaterial, das verwendet wird, um die mit Mustern versehenen Bereiche auf der Halbleiterscheibe zu erzeugen.

Das Verfahren und die Vorrichtung nach der Erfindung stellen eine Verbesserung der aus dem vorher erwähnten US Patent bekannten Verfahren und Vorrichtung dadurch dar, daß es nicht notwendig ist, die den Strahlquerschnitt for-

FI 980 066

menden Signale mehrere Male am Tage einzustellen. Die Vorrichtung nach der Erfindung erfordert lediglich eine Prüfung des Leuchtfleckes pro Tag, die zu Beginn eines jeden Betriebstages vorgenommen werden kann, wobei eine Neueinstellung nach mehreren Tagen oder Wochen erforderlich ist, um das gewünschte Bild der Strahlquelle zu erhalten.

Die Erfindung erfordert auch keinerlei Verringerung der Stromdichte. Daher kann eine verhältnismäßig hohe Stromdichte wie beispielsweise 50 A/cm$^2$ verwendet werden.

Der Erfindung, wie sie in den Ansprüchen gekennzeichnet ist, liegt die Aufgabe zugrunde, ein Verfahren und eine Vorrichtung zum Korrigieren der Ausrichtung eines Elektronenstrahles anzugeben, die gegen kleine Bewegungen des Bildes der Strahlquelle unempfindlich sind.

Im folgenden wird die Erfindung in Verbindung mit den Zeichnungen näher erläutert, von denen zeigen:

Fig. 1    eine schematische Schnittzeichnung eines Elektronenstrahlgerätes, bei dem der Strahl gemäß der Erfindung ausgerichtet wird und die einen Strahlengang zeigt, wenn keine Ablenkung erfolgt, um einen Strahl veränderbaren Querschnitts zu bilden oder um den Strom des Bildes der Strahlquelle abzufühlen;

Fig. 2    eine schematische Schnittzeichnung, die ähnlich wie die nach Fig. 1 den Strahlengang für das Abbilden der Quelle zeigt;

Fig. 3    eine schematische Schnittansicht die, ähnlich der nach Fig. 1, den Strahlengang bei der Abbildung der Öffnung zeigt;

FI 980 066

Fig. 4          eine schematische Schnittansicht und ein
                Blockschaltbild der Anordnung zum Ausrichten des Strahles außerhalb der optischen
                Achse;

Fig. 5          eine Kurve, die die Gauß'sche Verteilung
                der Stromdichte bei sich überschneidenden
                Strahlen (Quellenabbildung) darstellt;

Fig. 6          eine schematische Darstellung, die die Ver-
                schiebung der Gauß'schen Stromdichtevertei-
                lung nach Fig. 5 relativ zu einer Öffnung
                darstellt, die einen Durchmesser von etwa
                der Halbwertsbreite der Gauß'schen Stromdichteverteilung aufweist;

Fig. 7          eine schematische Darstellung, die das Ver-
                schieben der Gauß'schen Stromdichtevertei-
                lung nach Fig. 5 relativ zu einer Öffnung
                zeigt, die einen Durchmesser aufweist, der
                wesentlich größer als die Halbwertsbreite
                der Gauß'schen Verteilung der Stromdichte
                nach Fig. 5 ist;

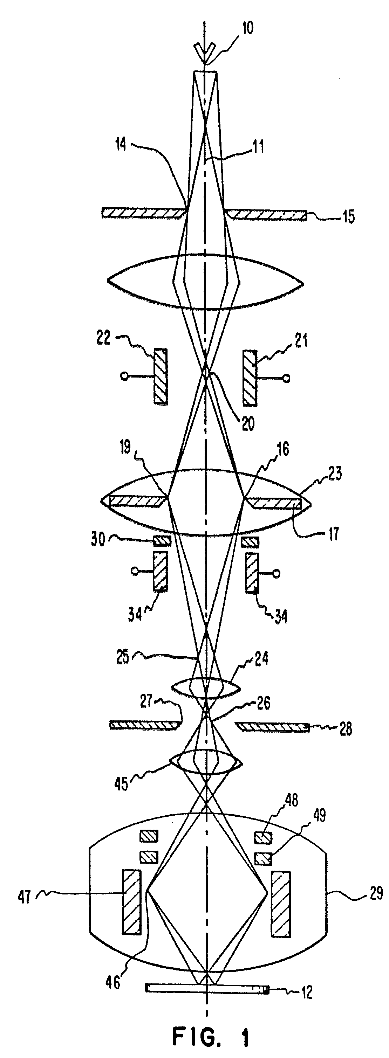

In Fig. 1 ist eine Quelle 10 dargestellt, die ein geladene
Teilchen, vorzugsweise Elektronen, liefernder Heizfaden
ist, und einen Elektronenstrahl längs einer optischen Achse
11 zu einer Auftreffplatte 12 lenkt. Die Auftreffplatte 12
kann beispielsweise eine Halbleiterscheibe sein, die von einem Resistmaterial bedeckt ist, in dem ein Muster durch den
von der Elektronenquelle 10 erzeugten Elektronenstahl auszubilden ist.

Wie genauer in der früher erwähnten US Patentschrift
4 243 866 dargestellt und beschrieben ist, wird der von
der Elektronenquelle 10 stammende Strahl für die Anwen-

FI 980 066

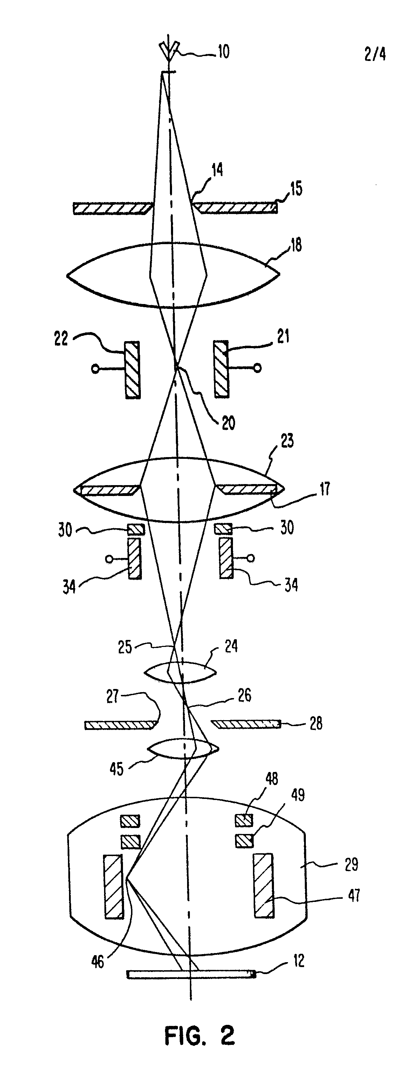

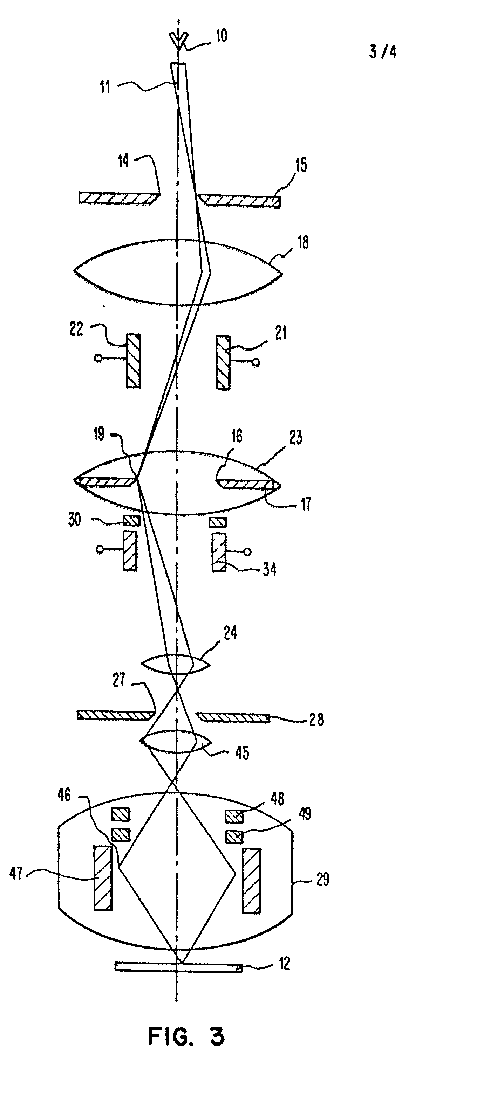

dung auf der Auftreffplatte 12 in einen Leuchtfleck mit veränderbarem rechteckigen Querschnitt geformt, in dem der Strahl zuerst durch eine Öffnung 14 tritt, die sich in einer Platte 15 befindet und vorzugsweise quadratisch ausgebildet ist. Der Strahlengang bei der Abbildung eines auf der linken Seite der Achse 11 sich befindenden Punktes der Elektronenquelle 10 ist in Fig. 2 dargestellt. Der Strahlengang für ein Bild eines Punktes am rechten Rand der ersten Öffnung 14 und der für das zusammengesetzte Bild, das durch die erste Öffnung 14 und eine zweite 16 gebildet wird, die vorzugsweise einen quadratischen Querschnitt aufweist und sich in einer Platte 17 befindet, ist in Fig. 3 dargestellt. Aus den Fign. 2 und 3 ist zu ersehen, daß der Strahlengang zur Abbildung der Quelle 10 den zur Abbildung der Öffnung in bestimmten Teilen der Fig. 1 überlagert.

Nach dem Durchlaufen der ersten quadratischen Öffnung 14, in der Platte 15 (vgl. Fig. 1) passiert der Strahl eine Kondensorlinse 18, die zweckmäßigerweise eine magnetische Linse von in der Elektronenstrahltechnik üblichem Entwurf ist. Die Kondensorlinse 18 fokussiert ein Bild 19 der Öffnung 14 in der Ebene der Öffnung 16.

Die Kondensorlinse 18 dient auch dazu, um ein Bild 20 der Elektronenquelle 10 auf einen Punkt längs der Achse 11 und in der Mitte der Ablenkvorrichtung zu fokussieren, die vier elektrostatische Platten, von denen zwei mit den Bezugsziffern 21 und 22 bezeichnet sind, umfaßt. Die elektrostatischen Platten 21 und 22 lenken das fokussierte Bild 19 der ersten quadratischen Öffnung 14 bezüglich der zweiten quadratischen Öffnung 16 in einer von zwei orthogonalen Richtungen (X und Y) während der Formung des Strahlquerschnittes ab, wie das genauer in der vorher genannten US Patentschrift 4 243 866 gezeigt und beschrieben ist. Die Ablenkvorrichtung schließt ein zweites Paar von Platten ein, um den Strahl seitlich in der anderen der beiden orthogonalen (X und Y) Richtungen während der Formung des Strahlquerschnittes abzulenken.

In der in dem US Patent 4 243 866 näher gezeigten und beschrieben Weise wird der virtuelle Mittelpunkt der Ablenkung, die durch die elektrostatischen Ablenkplatten, von denen zwei mit 21 und 22 bezeichnete dargestellt sind, in Koinzidenz mit der Ebene aufrechterhalten, in der die Abbildung 20 der Quelle durch die Kondensorlinse 18 abgebildet wird. Daher hat die Ablenkung des Bildes 19 der ersten Öffnung 14 zur Formung des Strahles keinerlei Auswirkung auf das fokussierte Bild 20 der Quelle.

Die Brennweite der Kondensorlinse 18 wird hauptsächlich dadurch bestimmt, daß das Bild 19 der Öffnung (14) in der Ebene der Öffnung 16 fokussiert wird. Dies ist der Grund dafür, daß das Fokussieren des Bildes 20 der Quelle nicht notwendigerweise an dem virtuellen Mittelpunkt der Ablenkvorrichtung auftritt.

Um für die wirkungsvollste und gleichmäßigste Beleuchtung durch den Strahl zu sorgen, d.h. für eine konstante Stromdichte, bildet eine zweite Kondensorlinse 23, bei der es sich um eine übliche magnetische Kondensorlinse handeln kann, innerhalb derer die zweite, mit einer Öffnung versehene Platte 17 angeordnet ist, das Bild 20 der Quelle auf die Eingangspupille einer ersten Verkleinerungslinse 24 ab. Um das Bild 20 der Quelle genau in der Eingangspupille der ersten Verkleinerungslinse 24 mit Hilfe der zweiten Kondensorlinse 23 abzubilden, ist es notwendig, daß das Bild 20 der Quelle während jeder Ablenkung des fokussierten Bildes 19 in der X- oder Y-Richtung stationär bleibt.

Die zweite Kondensorlinse 23 bewirkt, daß ein Bild 25 der Quelle sich nahe der vorderen Brennebene der ersten Verkleinerungslinse 24 befindet. Diese erzeugt ein vergrößertes Bild 26 der Quelle 10 in der Ebene einer Ausblendplatte 28. Die Lage des Bildes 26 der Quelle 10 ist abhängig von der Lage des Bildes 20 der Quelle. Der Durchmesser der Öffnung 27 in der Ausblendplatte 28 ist zumindest zwei mal so groß als die Halbwertsbreite der Gauß'schen Verteilung der Stromdichte des Bildes 26 (Strahlüberkreuzung) der Quelle 10. Dies verhindert es, daß irgendwelche kleinen Bewegungen des Bildes 26 Änderungen in der Stromdichte in der Ebene der Auftreffplatte 12 verursachen.

Wie das in Fig. 5 dargestellt ist, ist die Halbwertsbreite die Größe der Gauß'schen Verteilung der Stromdichte der sich überschneidenden Strahlen von der Quelle 10 bei 50% der maximalen Stromdichteverteilung und ist mit W bezeichnet. Wenn eine Öffnung A (vgl. Fig. 6) von im wesentlichen dem gleichen Durchmesser wie die Halbwertsbreite W (vgl. Fig. 5) verwendet wird, ändert jede Bewegung des Strahles bezüglich der Öffnung A, wie das in Fig. 6 dargestellt ist, wesentlich den Strom, der die Öffnung A passiert. Wenn jedoch eine Öffnung B wesentlich größer ist als die Halbwertsbreite, wie das in Fig. 7 dargestellt ist, dann hat eine leichte Verschiebung des Strahles keine Wirkung auf den durch die Öffnung B hindurchtretenden Strom.

Diese Beziehung, daß der Durchmesser der Öffnung 27 (vgl. Fig. 1) zumindest zweimal so groß ist wie die Halbwerts-

FI 980 066

- 9 -

breite der Gauß'schen Verteilung der Stromdichte des Bildes 26 der Quelle wird dadurch beeinflußt, daß die Größe
der Elektronenquelle 10 so gewählt wird, daß der Durchmesser der sich überkreuzenden Strahlen der Quelle 10
den Durchmesser des Strahles mehr bestimmt als der Durchmesser der Öffnung 27. Daher braucht die Öffnung 27 den
Strahldurchmesser in einer Projektionslinse 29 nicht zu
begrenzen.

Die Vorrichtung nach der Erfindung schließt ein Ausricht-
Joch 30 ein, das ein Paar von orthogonalen Spulen aufweist
in der gleichen Weise, wie das genauer in dem US Patent
3 894 271 dargestellt und beschrieben ist. Das Ausricht-
Joch 30 empfängt Korrektursignale von einer Ausricht-
Steuerschaltung 33 (vgl. Fig. 4) in der in dem US Patent
3 894 271 dargestellten und beschriebenen Weise.

Nachdem der Strahl die zweite Kondensorlinse 23 verläßt,
passiert er das Ausricht-Joch 30 und dann ein Paar von
Ausblendplatten 34, die bestimmen, wann der Strahl auf
die Auftreffplatte 12 (vgl. Fig. 1) gelenkt und wann er
ausgeblendet wird. Der Strahl wird ausgeblendet, indem er
zu der Ausblendplatte 28 abgelenkt wird. Er durchläuft
die erste Verkleinerungslinse 24 so, daß das Bild 25 der
Quelle vergrößert wird.

Die Ausblendplatten 34 sind in der Lage, das Bild 25 der
Quelle um eine Strecke zu bewegen, die das 4- bis 5-fache
des Strahldurchmessers beträgt, so daß ein verhältnismäßig
großer Durchmesser der kreisförmigen Öffnung 27 in der
Ausblendplatte 28 das Ausblenden des Strahles, wenn das
erwünscht ist, nicht verhindert, wie das genauer in dem
US Patent 3 644 700 erläutert ist. Wenn die Ausblendplatten

FI 980 066

34, die ein Paar von elektrostatischen Ablenkplatten sind, den Strahl von der Öffnung 27 wegbewegen und in Kontakt mit der Ausblendplatte 28 bringen, kann der Strahl die Auftreffplatte 12 nicht erreichen.

Wie das in dem US Patent 3 894 271 erläutert ist, bewegt sich der Strahl in einem A-Zyklus, einem B-Zyklus und einem C-Zyklus, worauf die Folge nach jedem C-Zyklus wieder mit dem A-Zyklus beginnt. Der Strahl wird während einiger oder aller der A-, B- und C-Zyklen ausgeblendet, abhängig von der speziellen Operation, die gerade ausgeführt wird. Alle diese verschiedenen Folgen, in der keiner, einer, zwei oder alle der A-, B- und C-Zyklen ausgeblendet werden, werden gesteuert durch die Zusammenarbeit zwischen einem (nicht dargestellten) Computer und einer (nicht dargestellten) Schnittstellenschaltung, wie das genauer in dem US Patent 3 894 271 dargestellt und beschrieben ist.

Beim Beaufschlagen eines Musters eines Resistmaterials auf einer Halbleiterscheibe, die die Auftreffplatte 12 darstellt, erfolgt das Beaufschlägen des Resistmaterials während des B-Zyklus. Während des C-Zyklus wird die Auftreffplatte 12, die auf einem Tisch befestigt ist, durch Bewegen des Tisches bewegt, um einen anderen Bereich der Auftreffplatte 12 in die Position zu bringen, in der der Strahl auf sie gerichtet werden kann.

Es ist während dieses letzten C-Zyklus, währenddessen die Auftreffplatte 12, die auf dem Tisch befestigt ist, durch Bewegung des Tisches bewegt wird, daß die Ausricht-Steuerschaltung 33 (vgl. Fig. 4) wirksam ist. Während dieser Zeit wird der Strahl durch das Ausricht-Joch 30 auf eine zweite kreisförmige Öffnung 35 gelenkt, die einen Durchmesser besitzt, der gleich der Halbwertsbreite der Stromdichteverteilung des Bildes 26 der Strahlquelle in der Ausblendplatte 28 ist.

Eine Abfühlplatte 36 ist direkt unter der Ausblendplatte 28 angeordnet und von dieser durch eine dünne Scheibe 37 aus Glimmer oder einem anderen geeigneten Isoliermaterial getrennt. Die Scheibe 37 ist sehr dünn, um irgendwelche Ladungsprobleme zu vermeiden. Die Abfühlplatte 36 hat eine zentrale kreisförmige Öffnung 38, die mit der kreisförmigen Öffnung 27 in der Ausblendplatte 28 ausgerichtet und größer als die Öffnung 27 ist, so daß die Abfühlplatte 36 nicht die normale Operation des Strahles stört.

Wenn es erwünscht ist, den Elektronenstrahl auf die Öffnung 35 in der Ausblendplatte 28 zu richten, werden feste Ablenkspannungen in zwei orthogonalen Richtungen als Signale dem Ausricht-Joch 30 zugeführt. Diese festen Ablenkspannungen werden während des Ausrichtens eingeschaltet und von einem Ablenk-Gleichspannungsgenerator 39 der Ausricht-Steuerschaltung 33 an eine Joch-Treiberschaltung 40 geliefert, die die orthogonalen Spulen des Ausricht-Joches 30 speist.

Wenn der Strahl auf die Öffnung 35 in der Ausblendplatte 28 abgelenkt wird und dies nur während der C-Zyklen erfolgt, wie das genauer in dem US Patent 3 894 271 beschrieben ist, wird der Strom von der Abfühlplatte 36 gesammelt, die den maximalen Strom abfühlt, wenn der Strahl auf die Achse 11 ausgerichtet ist. Dies liegt daran, daß eine Fehlausrichtung des Strahles auf die Achse 11 an der Öffnung 27 der Ausblendplatte 28 eine gleiche Fehlausrichtung an der Abfühlöffnung 35 in der Ausblendplatte 28 zur Folge hat.

Weil die kreisförmige Öffnung 35 einen Durchmesser hat, der gleich der Halbwertsbreite der Gauß'schen Verteilung

FI 980 066

- 12 -

der Stromdichte des Bildes 26 der Strahlquelle ist, resultiert jede Bewegung des Strahles aus seiner Ausrichtung auf die Achse 11 in einer Änderung des von der Abfühlplatte 36 aufgefangenen Stromes. Daher kann der maximale Strom von der Abfühlplatte 36 nur dann eingefangen werden, wenn der Strahl auf die Achse 11 ausgerichtet ist, da dies der einzige Zeitpunkt ist, zu dem die Gauß'sche Verteilung der Stromdichte der Abbildung 26 der Strahlquelle einen maximalen Strom durch die Öffnung 35 schickt.

Dies kann anhand der Fig. 6 nachgewiesen werden, bei der irgendeine Verschiebung der Gauß'schen Verteilung der Stromdichte eine Verringerung des Stromes zur Folge hat, der durch die Öffnung A tritt. Die Öffnung A entspricht der Abfühlöffnung 35 (vgl. Fig. 4) in der Ausblendplatte 28.

Der Strom, der durch die Abfühlplatte 36 überwacht wird, wird als ein Signal einem Fehlerdetektor 41 der Ausricht-Steuerschaltung 33 zugeführt. Der Fehlerdetektor 41 wird von einer Logikschaltung 42 für die zeitliche Steuerung gesteuert, wobei die Logikschaltung 42 durch einen (nicht dargestellten) Computer über die (nicht dargestellte) Schnittstellenschaltung gesteuert wird, wie das in dem US Patent 3 894 271 dargestellt und beschrieben ist.

Das Fehlersignal des Fehlerdetektors 41 wird den Korrekturschaltungen 43 zugeführt, die Korrektursignale für die Joch-Treiberschaltung 40 entsprechend dem Ausgangssignal des Fehlerdetektors 41 erzeugen. Wie schon vorher erwähnt, empfängt die Joch-Treiberschaltung 40 Ablenksignale von dem Ablenkgenerator 39, der durch die Logik 42 für die zeitliche Steuerung gesteuert wird, um die festen Ablenk-Gleichspannungen zu liefern, die bewirken, daß der Strahl

FI 980 066

durch die Ausblendplatten 34 auf die Öffnung 35 in der
Abfühlplatte 28 gelenkt wird.

Die Joch-Treiberschaltung empfängt auch ein Eingangssignal von einem Potentiometer 44 zum manuellen Ausrichten, das zu der Ausricht-Steuerschaltung 33 gehört. Das Potentiometer 44 zum manuellen Ausrichten wird manuell eingestellt zu dem Zeitpunkt des Einschaltens des Gerätes zur Erzeugung des Elektronenstrahles durch die Quelle 10 (siehe Fig. 1), so daß der maximale Strom des Strahles durch die Abfühlöffnung 35 (vgl. Fig. 4) einem zentrierten Bild der Quelle in der Projektionslinse 29 (vgl. Fig. 1) entspricht, wenn der Strahl durch die Öffnung 27 in der Ausblendplatte 28 tritt.

Daher wird der Strahl unter Verwendung der Ausgangsspannung der Korrekturschaltungen 43 (vgl. Fig. 4) entsprechend dem ihnen von dem Fehlerdetektor 41 zugeführten Eingangssignal von der Achse 11 weg ausgerichtet, so daß er längs der Achse 11 ausgerichtet ist, wenn er dahin zurückkehrt. Diese Ausrichtung tritt während jedes C-Zyklus der Folge der A-, B- und C-Zyklen auf, in denen die Auftreffplatte 12 (vgl. Fig. 1) dem Strahl ausgesetzt wird.

Es sei bermerkt, daß die Korrektursignale für die Joch-Treiberschaltung 40 (vgl. Fig. 4) von den Korrekturschaltungen 43 durch Bewegen des Strahles in kleinen Schritten abwechselnd in die beiden orthogonalen (X- und Y-)Richtungen ausgewertet werden. Dies wird solange fortgesetzt, bis die Abfühlplatte 36 den maximalen Strom abfühlt.

Wenn der Strahl in die Position zurückkehrt, in der er auf die Auftreffplatte 12 (vgl. Fig. 1) auftrifft, liefert der Ablenk-Gleichspannungsgenerator 39 (vgl. Fig. 4) keine Signale an den Joch-Treiber 40. Dies wird über die Logikschaltung 42 zur zeitlichen Steuerung erreicht, die von der (nicht dargestellten) Schnittstellenschaltung und dem (nicht dargestellten) Computer in der Weise gesteuert wird, wie in dem US Patent 3 894 271 näher dargestellt und beschrieben ist.

Daher wird der Strahl jedes Mal, wenn er längs der Achse 11 und durch die Öffnung 27 auf die Auftreffplatte 12 (vgl. Fig. 1) gerichtet wird, genau auf die Achse 11 ausgerichet, so daß die Öffnung 27 doppelt so groß sein kann als die Halbwertsbreite der Stromdichte-Verteilung des Bildes 26 der Quelle, wodurch es nicht notwendig ist, sich auf den Durchmesser der Öffnung 27 in der Ausblendplatte 28 für das Zentrieren des Strahles in der Projektionslinse 29 zu verlassen.

Mit dem so auf die Achse 11 ausgerichteten Strahl, der bezüglich der Projektionslinse 29 zentriert ist, erzeugt die erste Verkleinerungslinse 24 das vergrößerte Bild 26 der Quelle 10 in der Ebene der Öffnung 27 der Ausblendplatte 28. Das vergrößerte Bild 26 der Quelle 10 ist auf die Achse 11 in Folge der Korrektursignale für das Ausricht-Joch 30 ausgerichtet.

Eine zweite Verkleinerungslinse 45 vergrößert das Bild 26 der Quelle so, daß es in der Mitte 46 der Projektionslinse 29 abgebildet wird. Diese definiert auch den Halbwinkel der Konvergenz, welches der Winkel der äußeren Linie des Strahles von der Auftreffplatte 12 bezüglich der Achse 11 ist.

Wie in dem US Patent 4 243 866 dargestellt und beschrieben, ist ein Ablenkjoch 47 innerhalb der Projektionslinse 29 angeordnet. Das Joch 47 arbeitet in der in der

FI 980 066

US Patentschrift 3 644 700 näher dargestellten und beschriebenen Weise, um den Strahl über das Feld der Auftreffplatte 12 abzulenken.

Die Projektionslinse 29 schließt auch einen dynamischen Stigmator 48 und eine dynamische Fokussierspule 49 in der in dem US Patent 4 243 866 dargestellten und beschriebenen Weise ein. Der dynamische Stigmator und die dynamische Fokussierspule 49 arbeiten zusammen, um übliche dynamische Elemente zur Korrektur von Feldkrümmung und axialer und Ablenkungsastigmatismen zu bilden.

Bei der Betrachtung der Wirkungsweise der Erfindung ist davon auszugehen, daß der Strahl anfänglich manuell in der Projektionslinse 29 durch Einstellen des manuellen Ausrichtpotentiometers 44 (vgl. Fig. 4) der Ausricht-Steuerschaltung 33 zentriert wird. Dieses manuelle Ausrichten erfolgt zum Zeitpunkt der Inbetriebnahme des Gerätes.

Dann, wenn der Strahl der Auftreffplatte 12 (vgl. Fig. 1) von der Quelle 10 zugeführt wird, überwacht die Ausricht-Steuerschaltung 33 (vgl. Fig. 4) das Ausrichten des Strahles auf die Abfühlöffnung 35 zu ausgewählten Zeitpunkten, um für die notwendige Korrektur zu sorgen. Dieses Überwachen mit Korrekturen ist von der Art, daß es nur nötig ist, die Ausrichtung des Lichtflecks zu Beginn jedes Betriebstages zu prüfen und manuelle Korrekturen nur nach mehreren Tagen oder Wochen vorzunehmen.

Ein Vorteil der Erfindung liegt darin, daß es die Bildqualität des Strahles verbessert. Ein anderer Vorteil ist der, daß die Erfindung die Empfindlichkeit gegenüber leichten Bewegungen des Bildes der Quelle verringert. Ein weiterer

FI 980 066

- 16 -

Vorteil ist darin zu sehen, daß die Erfindung die Wirksamkeit des Betriebes erhöht. Ein anderer Vorteil der Erfindung liegt darin, daß die Strahlausrichtung ohne eine auf der optischen Achse befindliche Öffnung zur Begrenzung des Strahles erfolgt.

FI 980 066

PATENTANSPRÜCHE

1. Verfahren zum Korrigieren der Ausrichtung eines Elektronenstrahles, gekennzeichnet durch folgende Verfahrensschritte:

a) Elektronenoptisches Abbilden der Strahlquelle (10; Fig. 1) auf eine zentrale, kreisförmige Öffnung (27; Fig. 4) einer Ausblendplatte (28), deren Öffnung einen genügend großen Durchmesser besitzt, so daß die Stromdichteverteilung des Bildes der Strahlquelle in dieser Öffnung nicht merklich durch Verschiebungen des Bildes relativ zur optischen Achse (11) beeinflußt wird;

b) Ablenken des Elektronenstrahles zu ausgewählten Zeiten auf eine zweite kreisförmige Öffnung (35) der Ausblendplatte (28);

c) Genaues Ausrichten des Bildes der Strahlquelle mittels eines Ablenk-Joches (30) auf die zweite Öffnung der Ausblendplatte und

d) Rückführen des ausgerichteten Elektronenstrahles auf eine Auftreffplatte (12).

2. Verfahren nach Anspruch 1, dadurch gekennzeichnet, daß das genaue Ausrichten des Bildes der Strahlquelle auf die zweite Öffnung der Ausblendplatte durch kleine Verschiebungen dieses Bildes erfolgt.

3. Verfahren nach Anspruch 2, dadurch gekennzeichnet, daß das genaue Ausrichten des Bildes der Strahlquelle auf die zweite kreisförmige Öffnung der Ausblendplatte durch den Maximalwert des durch diese Öffnung fließen-

FI 980 066

den Elektronenstromes festgestellt wird.

4. Vorrichtung zur Durchführung des Verfahrens nach den Ansprüchen 1 bis 3, dadurch gekennzeichnet, daß der Durchmesser der zentralen, kreisförmigen Öffnung der Ausblendplatte mindestens etwa der doppelten Halbwertsbreite W der Stromdichteverteilung des Bildes der Strahlquelle in dieser Öffnung entspricht.

5. Vorrichtung nach Anspruch 4, dadurch gekennzeichnet, daß der Durchmesser der zweiten kreisförmigen Öffnung der Ausblendplatte etwa der Halbwertsbreite der Stromdichteverteilung des Bildes der Strahlquelle in dieser Öffnung entspricht.

FI 980 066

FIG. 1

FIG. 2

FIG. 3

FIG. 5

FIG. 6

FIG. 7

MANUELL. AUSRICHT-POT. 44

JOCH TREIBER 40

ABLENK-GENERATOR 39

KORREKTUR SCHALTUNGEN 43

FEHLER DETEKTOR 41

ZEITL. STEUERUNG 42

33

FIG. 4